# EUROPEAN PATENT APPLICATION

(11) **EP 0 971 387 A1**
(43) Date of publication of application: **12.01.2000**
(21) Application number: 99900465.8
(22) Date of filing: 22.01.1999
(51) Int. Cl.: H01J 37/12, H01J 37/317

(54) **ELECTRONIC LOW ENERGY SCANNING MICROSCOPE AND ELECTRONIC BEAM-OPERATED RECORDER BASED ON AN INTEGRATED PLANAR MICROLENS**

(30) Priority: 23.01.1998 ES 9800123
(71) Applicant: CONSEJO SUPERIOR DE INVESTIGACIONES CIENTIFICAS, 28006 Madrid (ES); Fisintec, S.L., 28100 Alcobendas (ES)
(72) Inventor: GARCIA GARCIA, Nicolás, Consejo Superior Inv., 28006 Madrid (ES); ZLATKINE, Alexandre, Consejo Superior Inv., 28006 Madrid (ES)
(74) Representative: Ungria Lopez, Javier
(86) International application number: ES9900016
(87) International publication number: WO9938187

(57) **Abstract**

The invention relates to a new concept of the column of an electronic microscope which is used to focus and deviate beams: the so-called microlens. Said microlens is a planar integrated chip, with dimensions of 1x1x0.05 cm³, produced entirely by using the microelectronic technology. The chip has two ultrathin silicon membranes with microscopic openings for the focusing of the electronic beam, and has also a co-planar quadripolar electrostatic deflector. The wide initial electronic beam is reduced to a small spot by applying to the membranes appropriate electronic potentials, and the deflector scans the beam focused along the length of the sample in order to obtain a scanned image of the sample ("microscope mode") or to inscribe a pattern thereon ("lithography mode").

## Description

### BACKGROUND

Since the invention of the Scanning Electronic Microscope (SEM) in the thirties, great efforts in research and development have been dedicated to the design and improvement of its key component - the column - that includes all the necessary elements for the creation of the electron beam, the focusing and deviation thereof [P.W. Hawkes and E. Kasper, *Principles of electron optics,* Academic Press, London (1989]. Although these microscopes are very widely used nowadays and there is a large variety of them, their main element, the column, is still large, complicated and expensive, especially for high resolution instruments. The subsequent use of the electronic scanning microscope as an instrument for electronic beam lithography (EBL) revealed its main limitation, since its throughput proves to be insufficient in direct inscription, which prevents the industrial application of this technique, which on the other hand is very effective.

The demand for a versatile low cost and low energy electronic scanning microscope and for an electronic beam-operated lithographic recorder in order to create structures in the scale below 100 *nm* has put on the agenda the task of developing and constructing a miniaturized optoelectronic column based on an electrostatic focus instead of a magnetic one. The idea of miniaturization was conceived (aside from other advantages) in order to prepare the way for a multicolumn - namely, a collection of focused electronic beams that could be inscribed simultaneously and therefore the throughput of electron beam lithography (EBL) would substantially increase.

The study in this direction started in the United States by T. H. P. Change and et al.- in the eighties, and in the middle of the nineties they informed about an operative microcolumn, with a size smaller than 3 cm³ with a Schottky emitter operating in the range of 1-2 keV, and a resolution of 12 *nm* in the transmission mode of the electronic scanning microscope [E. Kratschmer, H.S. Kim, M.G.R. Thomson, K.Y. Lee, S.A. Rishton, M.L. Yu and T.H.P. Chang, "*An electron beam microcolumn with improved resolution, beam current and stability",* J. Vac. Sci. Technol. B 13(6) (1995) 2498; T.H.P. Chang, M.G.R. Thomson, M.L. Yu, E. Kratschmer, H.S. Kim, K.Y. Lee, S.A. Rishton and S. Zolgarnain, *"Electron beam technology - SEM to microcolumn",* Microelectronic Eng., 32(1996) 113]. However, the design and especially the technology of this microcolumn does not permit it to be incorporated in a matrix of beam-operated recorders: (1) all the elements (more than ten) are produced separately and must be assembled manually afterwards with very high precision; (2) the head of the Scanning Tunneling Microscope (STM) is needed in order to precisely place the emitter in the vacuum chamber very close to the input aperture; (3) the Schottky emitter used dissipates a power of 2-3 W per beam which is unacceptable for recorders being formed. Besides, the electronic energy of which part has been given for this column could not be less than 1000 eV - although this is low in comparison with conventional electronic scanning microscopes, it is still sufficient to cause detectable proximity effects [M. McCord and M.J. Rooks, *"Electron beam lithography"*, in: Handbook of microlithography, micromachining and microfabrication / P. Rai-Choudhury, Editor. Volume 1, pp. 139-250 SPIE Optical Engineering Press, 1997].

Unlike the latter, the invention filed is based on the microlens produced by means of microelectronic technology in a cycle; this main characteristic makes an electronic beam marker matrix rather feasible.

### DESCRIPTION OF THE INVENTION

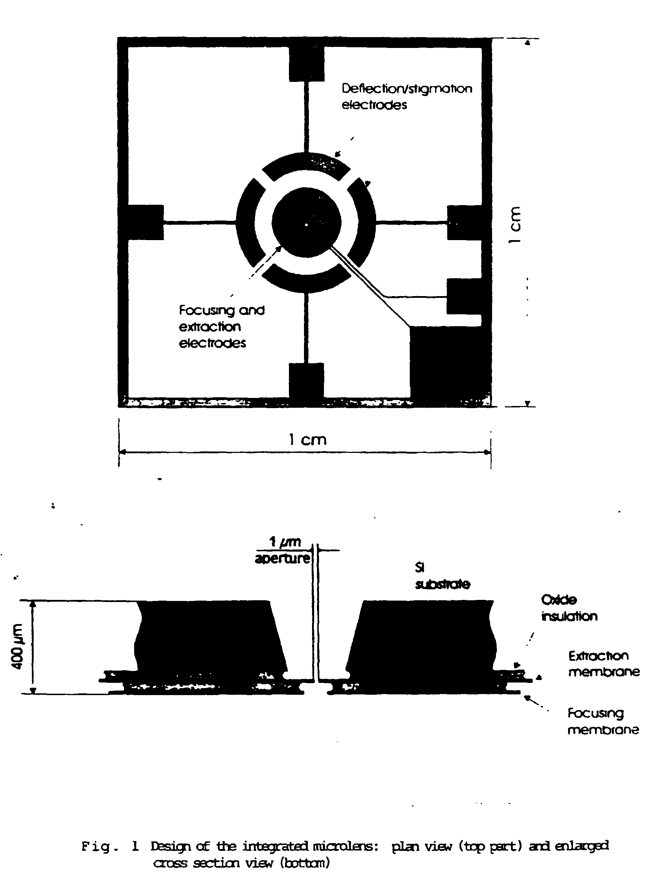

The pattern of the integrated optoelectronic system (microlens) is shown in figure 1. It is a planar silicon chip with some dimensions of 1x1x0.05 cm³.

The chip is comprised of two ultrathin silicon membranes (0.5 µ*m* wide) grown on a thicker substrate, and four coplanar deflection electrodes. The 1 µ*m* hole (first aperture) has been made in the first membrane whose role consists of extracting the electrons from an emitter and spatially restricting the initial beam. The second focusing membrane is separated from the first one by an insulating strip (SiO₂) and has a larger hole with a diameter of about 50 µ*m* whose axis is well aligned with the first perforation.

Quadrupolar deflection is represented as four fourths of a planar O-ring placed symmetrically around the center holes. Some suitable conducting strips connect the membranes and the deflection unit with the contact areas where the outside connections of the chip will be carried out.

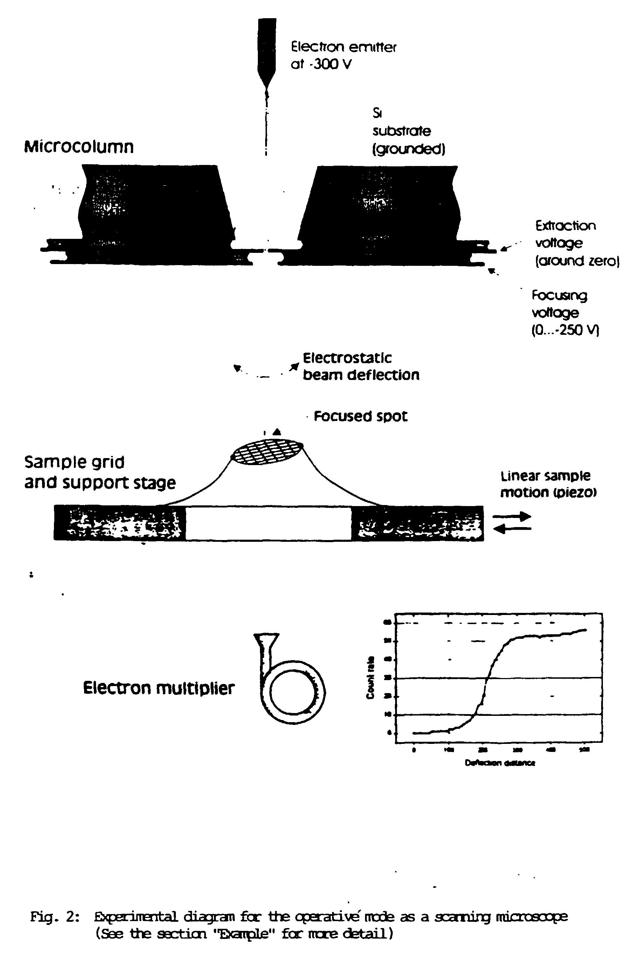

As shown in figure 2, the initial electronic beam that passes through the cavity in the substrate of the chip is first cut by the extraction hole; then, with the electronic delay potential applied to the focusing membrane, the electronic paths are concentrated by the focusing field on a minute spot. The focusing distance may be controlled by means of the membrane potentials.

When equal electric potentials but with the sign opposite to the opposite pairs of deflection segments are applied, the electronic beam is deviated sideways and consequently the focused spot can scan an area on the sample in order to produce an image in the electronic scanning microscope mode or in order to produce a pattern in the electronic beam lithography.

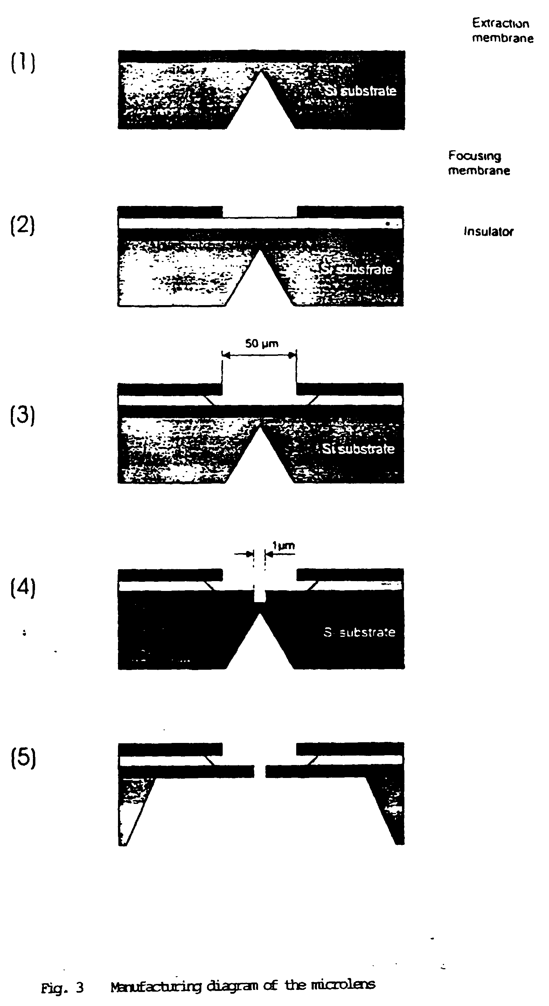

The manufacture of the microlens is based completely on conventional microelectronic technology: electronic beam lithography and electrochemical reactive ion etching (RIE). The flow diagram of the process is shown in figure 3. After the formation of the pyramidal cavity in the rear part of the silicon substrate, the extraction grid is defined (step 1). Isolated from the front by insulation with a thickness of one micron, the focusing and deflection electrodes are electrochemically stamped and etched (2). After local electrochemical etching of the insulation (3), a hole with a diameter of one micron is made by electronic beam lithography (4), and then the cavity is enlarged by RIE (5). The final step of manufacturing the lens is done *in situ* and includes thermal and electric field treatment in order to reduce leaks and increase the breaking stress of the electrodes.

As one can see, the arrangement and manufacturing technology of the proposed microlens provides the possibility of manufacturing a microlens matrix in a single substrate without implying any manual assembling or alignment step.

Another important differentiating characteristic of the proposed invention is that the throughput of the microlens does not depend on the type and characteristics (such as the size of the emitting area, etc. of the electron source. As shown in the example, the emitter is placed 1-2 *mm* above the microlens, in such a way that the size of the source is completely defined by the input aperture. This provides the opportunity to use any type of electronic emitter; thermal-ionic, Schottky or a cold field source. Furthermore, a wide beam source with a very large emitting area (such as a porous silicon surface [5]) can be used as a common emitter for a multicolumn collection.

### EXAMPLE

The previously described microlens has been manufactured and tested in an operative prototype of the electronic low energy scanning microscope made for this purpose. The experimental equipment is shown schematically in figure 2.

The microlens was installed horizontally in a console support in the vacuum chamber. It was a sharp tungsten tip which could have produced an initial electronic beam with a stream in the range of the microampere and an energy of 3000 eV.

In order to precisely estimate the diameter of the spot focused on the sample, a grid of thin gold strips was chosen as a sample. The sample grid was mounted on a platform with a translation mechanism in the three directions of space, led by a piezoelectric in such a way that the distance from the lens to the sample as well as the lateral position of the sample could be changed. A standard electron multiplier was used as a detector and counter of transmitted electrons.

When the beam is scanned on a grid bar the count of the detector changes from around zero (when the beam is shadowed completely by the bar) up to a maximum value, the width of this transition giving us the measurement of the size of the spot in the sample. The (negative) potential of the focusing membrane is chosen in such a way that it has a minimum width in the transition curve. On the other hand, if the beam scans a rectangular area with the help of a deflector of the microlens, a two-dimensional image of the sample can be obtained. In this case the resolution can be estimated by the standard method used in microscopy and it is given by the size of the minimum distinguishable stroke.

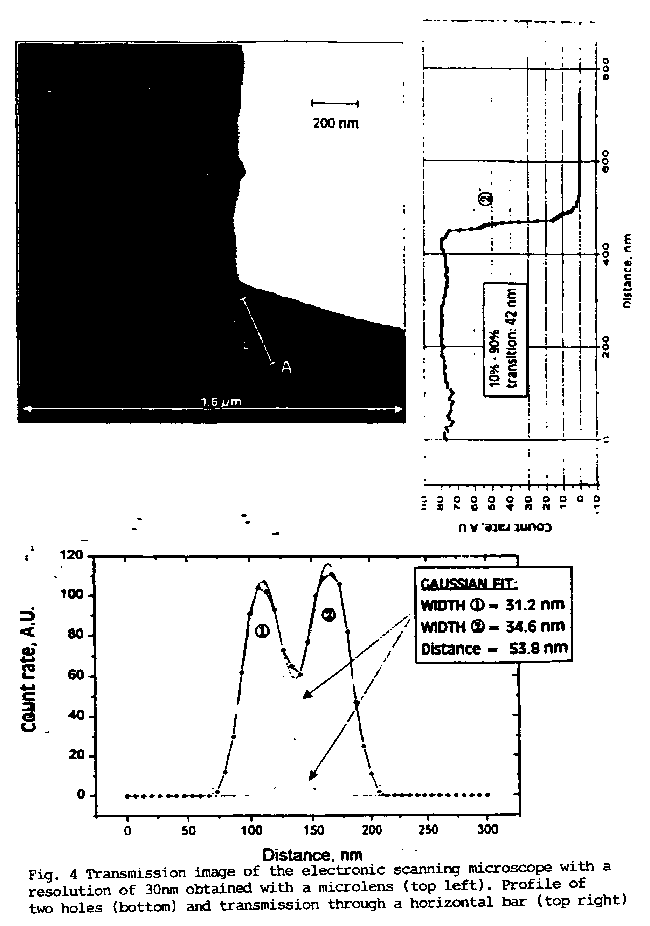

Figure 4 shows an example of the image in two dimensions of the sample thus obtained in the position in which two bars cross. The scanning range is 1.6x1.6 mm², the energy of the electron is 300 eV, the focusing voltage is - 175V. The presence of two small holes in the horizontal bar allows us to estimate the resolution achieved: as of the intensity profile shown in the bottom part of figure 4, a resolution of around 30 *nm* is easily determined.

## Claims

1. A new type of optoelectronic column based on the completely integrated ultracompact lens is proposed, the column offers a simple and cheap solution for the compact electronic low energy (below 350 eV) scanning microscope and an electronic beam lithography instrument to be used in the range of less than 100 *nm*.

2. The design of the microlens and, especially the manufacturing process allows the integration of multiple lenses in a matrix in order to carry out multiple electronic beam lithography, thus increasing the throughput of said electronic beam lithographic system up to an acceptable industrial level for direct inscription.

3. The operation and performance of the microlens does not depend on the type and characteristics of the electron emitter: there is no need of complicated process of preparation of emitters, placement and alignment.
